Europäisches Patentamt

European Patent Office

Office européen des brevets

(11) Numéro de publication: **0 317 024 B1**

(12) **FASCICULE DE BREVET EUROPEEN**

(45) Date de publication de fascicule du brevet: **15.06.94**

(51) Int. Cl.5: **H01L 27/144**, H01L 31/105, H01L 31/18

(21) Numéro de dépôt: **88202559.6**

(22) Date de dépôt: **16.11.88**

(54) **Procédé de réalisation d'un photodétecteur infrarouge intégré.**

(30) Priorité: **20.11.87 FR 8716090**

(43) Date de publication de la demande:
**24.05.89 Bulletin 89/21**

(45) Mention de la délivrance du brevet:
**15.06.94 Bulletin 94/24**

(84) Etats contractants désignés:
**DE FR GB NL SE**

(56) Documents cités:
**GB-A- 2 168 528**

**APPLIED PHYSICS LETTERS, vol. 49, no. 22, 1 décembre 1986, pages 1522-1524, American Institute of Physics, New York, US; S. MIURA et al.: "Planar, embedded InP/GaInAs p-i-n photodiode with very high-speed response characteristics"**

**IEEE TRANSACTIONS ON ELECTRON DEVICES, vol. ED-32, no. 11, novembre 1985, pages 2319-2321, IEEE, New York, US; B. TELL et al.: "Monolithic integration of a planar embedded InGaAs p-i-n detector with InP depletion-mode FET's"**

(73) Titulaire: **LABORATOIRES D'ELECTRONIOUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB NL SE**

(72) Inventeur: **Chane, Jean-Paul Société Civile S.P.I.D.**
**209, rue de l'Université**
**F-75007 Paris(FR)**
Inventeur: **Riglet, Philippe Société Civile S.P.I.D.**
**209, rue de l'Université**
**F-75007 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services
(3.10/3.09/3.3.3)

EP 0 317 024 B1

INTERNATIONAL ELECTRON DEVICES MEE-
TING - IEDM'83, Washington, DC, 5-7 décembre 1983, pages 478-481, IEEE, New York, US;
A.S.H. LIAO et al.: "A planar embedded In-
GaAs photodiode on semi-insulating InP
substrate for monolithically integrated pinfet receivers, using selective vapor phase
epitaxy and ion implantation technique"

ELECTRONICS LETTERS, vol. 20, no. 8, 12
avril 1984, pages 314-315, Londres, GB; K.
KASAHARA et al.: "Monolithically integrated
In0.53Ga0.47As-PIN/InP-MISFET photoreceiver"

IEEE JOURNAL OF OUANTUM ELECTRONICS,
vol. OE-21, no. 8, août 1985, pages 1236-1239,
IEEE, New York, US; K. OHNAKA et al.: "A
planar InGaAs PIN/JFET fiber-optic detector"

(74) Mandataire: **Landousy, Christian et al**
**Société Civile S.P.I.D.**
**156, Boulevard Haussmann**
**F-75008 Paris (FR)**

## Description

L'invention concerne procédé de réalisation d'un circuit intégré pour la détection du rayonnement infrarouge comprenant un substrat semi-isolant muni d'une photodiode PIN enterrée, d'un transistor à effet de champ à jonction J-FET dont la grille est connectée à la photodiode PIN, et une résistance R connectée au transistor, ce procédé incluant la croissance d'une première structure de couches épitaxiales de matériaux semiconducteurs dans laquelle est formé le transistor J-FET, la croissance d'une seconde structure de couches épitaxiales de matériaux semiconducteurs dans laquelle est formée la diode PIN, et la gravure d'un puits dans lequel la seconde structure de couches est réalisée.

L'invention trouve son application dans la réalisation de détecteurs infrarouges, notamment pour l'utilisation aux longueurs d'onde 1,3 et 1,55 $\mu$m dans les télécommunications. Le dispositif selon l'invention peut par exemple être couplé avec des guides de lumière.

Un procédé de réalisation pour obtenir un photodétecteur intégré comprenant une photodiode PIN, un transistor à effet de champ J-FET et une résistance, est connu de la demande de brevet GB 2168 528. Selon ce procédé, un puits et d'abord réalisé par gravure dans un substrat en InP semi-isolant, pour recevoir les couches qui formeront la photodiode. Ces couches comprennent une couche tampon de type $n^+$ qui sert aussi de contact n pour la diode et qui est réalisée soit par implantation ionique, soit par LPE ; une couche épitaxiale enterrée en GaInAs-$n^-$, réalisée par LPE, qui emplit le puits et qui déborde du puits pour s'étendre de façon planaire sur la région environnante. Ce procédé comprend alors la gravure de cette couche planaire de GaInAs-$n^-$ jusqu'à révéler la partie supérieure du puits empli de ce matériau, entourée du substrat InP ; la croissance épitaxiale par LPE de GaInAs-n ou de GaInAsP-n sur la surface totale du dispositif pour former la région de canal du J-FET ; la croissance épitaxiale par LPE de GaInAs-p ou d'Inp-p pour former la grille du J-FET ; la diffusion localisée d'atomes de zinc pour former la région p de la diode et l'interconnexion entre diode, grille du J-FET et future résistance. Ce procédé comprend enfin des gravures pour isoler les éléments, sauf dans les régions de connexions, et le dépôt de couches pour former la résistance et les contacts électriques. Notamment, le contact n de la diode est réalisé en mettant à nu la couche d'InP-$n^+$ lors de la réalisation d'un MESA autour de la diode. L'éclairement de cette diode est prévu par la face arrière du substrat.

Or il apparaît que, pour élaborer au cours d'une même mise en oeuvre un transistor J-FET et une diode PIN, il est nécessaire de bien maîtriser à la fois les épaisseurs des couches nécessaires à la réalisation de ces éléments, et le dopage de ces couches, car ces épaisseurs et ces dopages sont différents de l'une à l'autre des structures de couches constituant ces éléments.

Selon le procédé connu, notamment, la couche p formant la région p de la diode ne peut que présenter une épaisseur très importante du fait du mode de mise en oeuvre choisi. Une épaisseur aussi grande conduit à une mauvaise efficacité quantique qui nuit aux performances de la diode.

En outre, selon le procédé connu, la diode ne peut être formée que d'une simple hétérostructure, ce qui ne conduit pas à des performances optimales.

De plus, selon le procédé connu, chacune des couches est élaborée par épitaxie LPE avec un dopage de croissance donné, et en particulier, pour réaliser le transistor, une couche de GaInAs-p ou d'InP-p est réalisée par LPE en surface d'une couche de GaInAs-n ou de GaInAsp-n.

Or il est toujours difficile de réaliser deux couches de type de conductivité opposés, en surface l'une de l'autre par la même technologie, car les espèces servant à doper la première couche poluent le réacteur et donc la seconde couche durant son élaboration. Il est aussi difficile de réaliser deux couches de mêmes types de conductivité dopées à un niveau différent par la même technologie car alors la transition n'est pas abrupte et les couches sont mal différentiées. Il faudra donc se garder de réaliser la couche de type $n^+$ et la couche de type n de la diode par la même technologie comme la possibilité en est mentioneé dans le document cité.

Par ailleurs, le procédé connu inclut une étape selon laquelle une gravure est réalisée pour mettre à nu une surface qui comprend deux zones de matériaux différents : une première zone de GaInAs-$n^-$ correspondant à la région n de la diode dans le puits, et une deuxième zone entourant la première zone et constituée par le matériau du substrat en InP. Une telle gravure est très difficile à mener à bien si l'on veut obtenir une surface plane, car la gravure de matériaux différents tels que GaInAs et Inp s'effectue avec des taux très différents. Une telle étape doit donc impérativement être évitée.

Il faut encore noter que le dispositif connu ne peut être illuminé que par la face arrière du substrat ce qui est un inconvénient dans tous les cas où le dispositif photodétecteur n'est pas un composant discret, mais est incorporé dans un circuit intégré. Dans ce dernier cas il faut prévoir un dispositif pouvant être illuminé par la face supérieure du substrat.

3

La présente invention propose un procédé de réalisation d'un dispositif photodétecteur qui permet d'éviter ces différents inconvénients et qui est en outre simple à mettre en oeuvre.

Selon l'invention ces buts sont atteints au moyen du procédé défini dans le préambule et en outre caractérisé en ce que la gravure du puits est réalisée après croissance sur toute la surface du substrat semi-isolant de la première structure de couches épitaxiales et est pratiquée à travers cette structure jusque dans le substrat, et en ce que la croissance de la seconde structure de couches épitaxiales est localisée dans le puits, la surface supérieure de ladite seconde structure étant coplanaire avec celle de la première structure de couches.

Des mises en oeuvre particulières du procédé selon l'invention font de plus l'objet des revendications dépendantes.

Ce procédé présente entre autres les avantages suivants :
- l'épaisseur du dispositif est plus faible que celle du dispositif connu du fait que les couches du transistor sont déjà réalisées lorsqu'est entreprise la gravure du puits pour contenir la structure de diode ;
- l'épaisseur, la composition et le taux de dopage des couches sont mieux maîtrisés du fait que le dopage est réalisé indépendamment de la croissance des couches laquelle est effectuée au taux résiduel de dopage. Ainsi la couche p de la diode est de faible épaisseur et l'efficacité quantique en est améliorée. D'autre part, on peut réaliser à volonté une diode formée d'une simple ou d'une double hétérostructure du fait que la réalisation de l'empilement des couches de la diode se fait indépendamment de la réalisation du transistor. On peut ainsi obtenir une diode présentant les performances optimales. Toutes les couches peuvent présenter un niveau de dopage et une épaisseur optimisés. De plus la pratique du recuit d'implantation dans la chambre du réacteur utilisé pour l'élaboration des couches épitaxiales ultérieures permet une simplification de la mise en oeuvre, un gain de temps et la faculté de réaliser ce recuit sous une atmosphère contrôlée qui évite la détérioration de la surface ;
- la prévision d'une couche d'arrêt de gravure lors de l'élaboration de l'empilement des couches de diode dans le puits permet d'ouvrir une fenêtre pour réaliser le contact $n^+$ de diode sans endomager cette couche de contact.

L'invention sera mieux comprise au moyen de la description suivante illustrée par les figures annexées dont :
- Les figures 1a à 1k qui montrent en coupe les différentes étapes du procédé de réalisation de la photodiode et du transistor J-FET.
- Les figures 2a à 2c qui montrent en coupe les étapes de la réalisation du transistor T J-FET.
- Les figures 3a à 3c qui montrent en coupe les étapes de la réalisation de la résistance de charge du transistor.
- La figure 4 qui montre schématiquement le circuit électrique réalisé par les éléments du circuit intégré selon l'invention.
- La figure 5 qui montre, vu de dessus, un exemple de disposition du photodétecteur selon l'invention.
- La figure 6 qui montre en coupe l'interconnexion entre la grille du transistor T et le contact type p de la diode Δ.

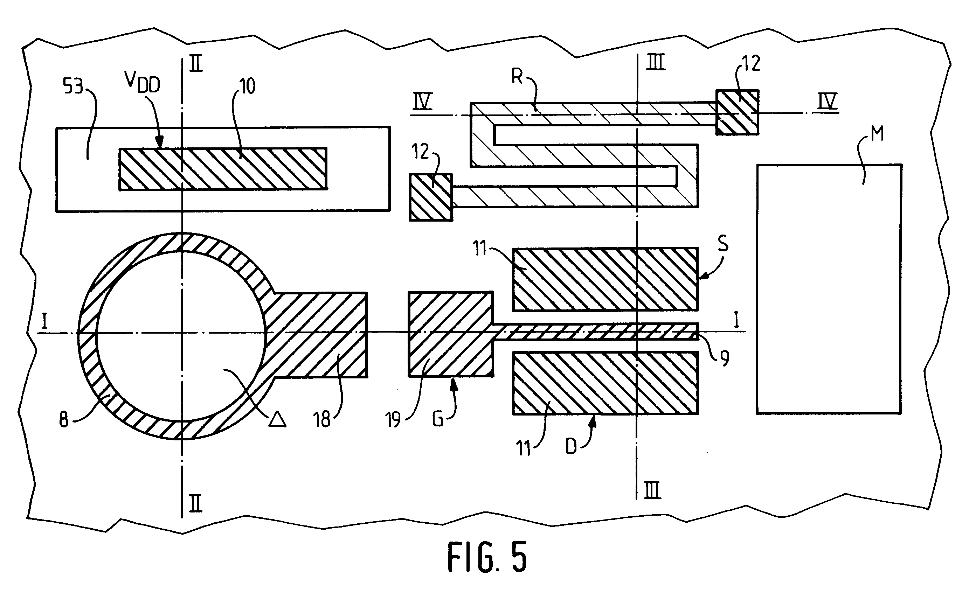

Tel que représenté schématiquement sur la figure 4 le dispositif photodétecteur selon l'invention comprend une photodiode PIN, Δ, dont le contact de type-n est relié à une ligne d'alimentation continue $V_{DD}$ et dont le contact de type-p est relié à la grille d'un transistor T de type J-FET. La grille de ce transistor T est donc un contact de type-p, et les source et drain, S et D, sont des contacts de type-n. La source S est reliée à une ligne de masse M et le signal détecté est disponible sur le drain D. Une résistance R de charge du transistor est disposée entre la grille et la masse. Selon l'application du dispositif, la tension $V_{DD}$ sera de l'ordre de 10V et la résistance R de charge pourra être choisie entre 50 Ω et 100 kΩ.

Le procédé selon l'invention permet de réaliser simultanément la photodiode, le transistor J-FET et la résistance de charge, ainsi que les plots d'entrées-sorties.

Il faut noter que cette réalisation simultanée rencontre trois principaux problèmes dûs à la différence de structure de ces composants.
- une différence d'épaisseur, c'est-à-dire de leur dimension perpendiculairement au substrat ; l'épaisseur de la photodiode PIN destinée à la détection des signaux de longueur d'onde 1,3 ou 1,55 $\mu$m et qui est constituée de $Ga_{0,47}In_{0,53}As/InP$ est de l'ordre de 5 à 5,5 $\mu$m. En revanche, le transistor présente une épaisseur qui n'excède pas 1 $\mu$m,
- une différence de dopage des couches actives, la couche active, de type $n^+$ dans le transistor, doit présenter un dopage de l'ordre de $10^{17}.cm^{-3}$, alors que la couche active, de type $n^-$ dans la photodiode, doit présenter un dopage de l'ordre de $10^{15}.cm^{-3}$,

- des zones de dopage bien localisées ; il faut en effet ménager sous la couche active de la photodiode, une couche de type de conductivité n$^{++}$ pour pouvoir réaliser le contact de type-n. Cette couche n$^{++}$ doit être bien séparée de la couche n$^-$ qui la recouvre.

En effet, dans le procédé connu de l'état de la technique, pour réaliser la photodiode, une couche d'InP de type n$^+$ est aussi réalisée sous la couche d'InP de type n$^-$ au fond du puits. Mais dans le document cité, il est dit que ces couches peuvent être réalisées dans le même réacteur, par la même méthode d'épitaxie, à la suite l'une de l'autre. Or, il est apparu qu'il était très difficile de dominer le passage du dopage n$^+$ au dopage n$^-$ ultérieur du fait des polutions du réacteur. Cette méthode est donc à déconseiller.

C'est pourquoi, selon l'invention ces couches seront réalisées par des procédés différents.

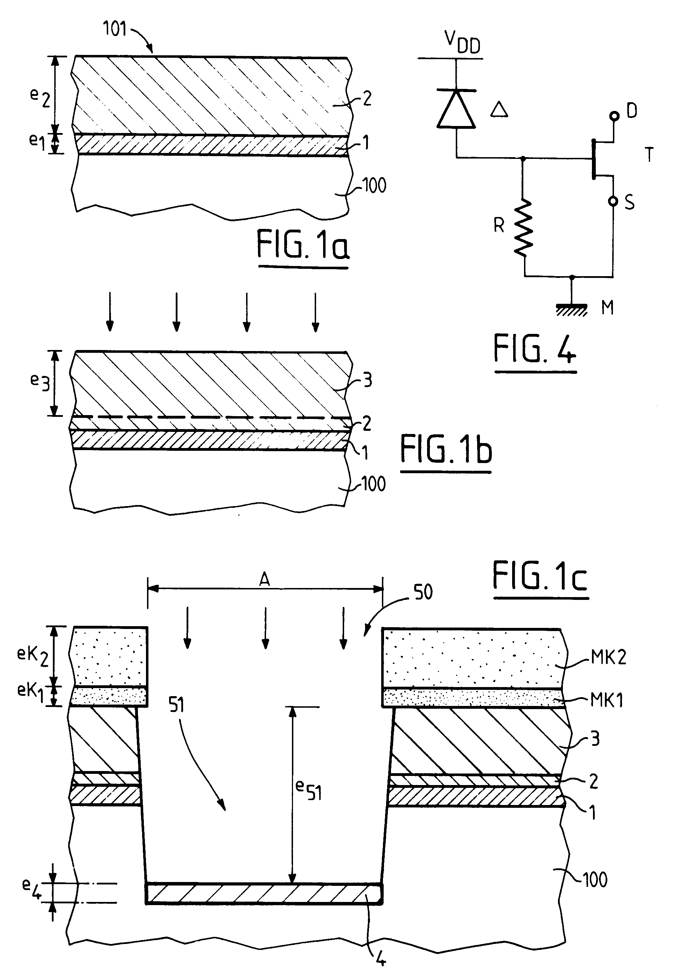

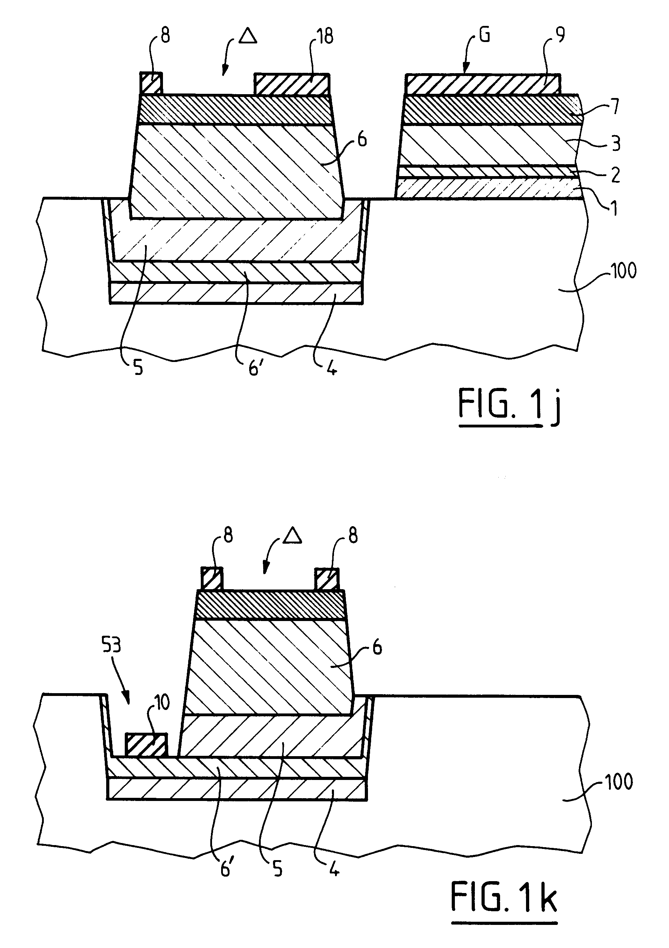

Tel qu'illutré par les figures 1a à 1k, représentant des coupes schématiques du dispositif, dont notamment les dimensions en épaisseurs sont très disproportionnées par rapport aux dimensions en largeur ou longueur pour la clarté de l'exposé, le procédé selon l'invention comprend les étapes suivantes :

a) formation d'un substrat 100 en phosphure d'indium (InP) monocristallin, présentant une face plane orientée, et semi-isolant. Le lingot a été par exemple obtenu par tirage par la méthode Czochralski sous encapsulation liquide selon l'axe cristallographique [001], et découpé en lamelles présentant des faces désorientées de 3° par rapport du plan cristallographique (001) pour assurer une meilleure reprise d'épitaxie, la désorientation étant parallèle à la direction [110]. Le monocristal est obtenu semi-isolant par dopage au chrome (Cr) (Voir la figure 1a).

b) formation sur toute la surface du substrat 100 d'une couche 1 de phosphure d'Indium (InP) non dopée intentionnellement. La méthode utilisée peut être ici soit une croissance épitaxiale en phase vapeur aux organométalliques (MOVPE), soit une croissance épitaxiale en phase vapeur aux chlorures. Cette couche 1 n'est pas indispensable, mais elle améliore la qualité de la couche suivante. Elle est très peu épaisse. Une épaisseur favorable sera par exemple $e_1 \leq 0,2\mu m$ (voir la figure 1a en coupe).

c) formation sur toute la surface du substrat 100 par la même méthode que précédemment d'une couche d'arséniure de gallium et d'indium (Ga$_{0,47}$In$_{0,53}$As) non dopée intentionnellement. Une épaisseur favorable sera par exemple $e_2$ telle que $0,5\mu m \leq e_2 \leq 1\mu m$.

d) implantation ionique sur toute la surface de la couche 2 d'arséniure de gallium et d'indium (GaInAs) pour former une couche 3 de type de conductivité n. La couche 3 de GaInAs de type n est destinée à constituer la couche active du transistor T à grille à jonction (J-FET). Cette implantation ionique du type n est réalisée au moyen d'ions Si$^{28}$, à une concentration de l'ordre de $10^{17}.cm^{-3}$, dans la couche 2 de GaInAs. Pour former la couche active 3, la profondeur d'implantation des ions Si sera favorablement $e_3$ telle que $0,4\mu m \leq e_3 \leq 0,9\mu m$. Un recuit d'implantation est réalisé dans le réacteur d'épitaxie sous pression partielle d'arsine (AsH$_3$) à 700° environ, pendant 15mn environ (voir la figure 1b en coupe).

e) recouvrement du dispositif total au moyen d'une couche diélectrique MK1, suivie d'une couche en photorésist MK2. La couche diélectrique MK1 pourra être par exemple en silice (SiO$_2$) d'épaisseur $eK1 \simeq 0,15\mu m$. La couche en photorésist sera au contraire très épaisse pour protéger le dispositif durant des étapes ultérieures de gravure et d'implantation ionique. A cet effet la couche MK2 présentera favorablement une épaisseur $eK2 \simeq 6\mu m$. (voir la figure 1c en coupe).

f) formation, dans la couche MK2 de photorésist, d'ouvertures 50 sur l'emplacement futur des photodiodes, par photolithographie. Ces ouvertures 50 seront favorablement de dimensions carrées A x A avec A $\simeq 200\ \mu m$.

g) gravure à travers les ouvertures 50, successivement de la couche diélectrique MK1, puis de la couche 3 en GaInAs de type n, couche 2 en GaInAs non dopée, couche 1 en InP non dopé, et du substrat jusqu'à former un puits 51 profond de $e_{51}$ tel que $5\mu m \leq e_{51} \leq 5,5\mu m$ dans les matériaux semiconducteurs (voir la figure 1c). La gravure de la couche diélectrique MK1 peut être faite chimiquement, par exemple au moyen d'acide fluorhydrique dilué. La gravure de la couche 2 en GaInAs peut être effectuée au moyen d'un mélange, en proportions volumiques de 4 H$_2$SO$_4$ + 1 H$_2$O$_2$ + 10 H$_2$O. La gravure de la couche 1 et du substrat 100 en InP peut être faite au moyen du mélange d'une solution normale de bichromate de potassium (en abrégé : K), d'acide acétique (en abrége :C), d'acide bromhydrique (en abrégé : B) dans les proportions volumiques : 1K + 1B + 1C. Dans certaines orientations cristallographiques, les flancs de gravure sont alors pratiquement perpendiculaires au plan des couches. Cependant une très petite "sous-gravure" apparaît sous les couches MK1/MK2 en bordure des ouvertures 50 (voir la figure 1c).

Toutefois, si l'ouverture 50 est disposée de telle manière qu'elle présente au moins un bord parallèle au plan cristallographique (110) alors le flanc de gravure le long de ce bord n'est pas perpendiculaire au substrat mais descend en pente douce vers le fond du puits. Cette propriété pourra être utilisée favorablement dans les étapes ultérieures pour réaliser le contact de type n de la diode au niveau de la surface supérieure du dispositif. Ce contact de type n pourra donc être réalisé selon deux méthodes comme il sera montré ultérieurement.

h) implantation ionique localisée dans l'ouverture 50 pour former dans le fond du puits 51, une couche 4 de type de conductivité $n^{++}$. Cette couche sera réalisée par exemple, par implantation d'ions $Si^{28}$, avec une énergie forte, par exemple 700 keV, pour obtenir une profondeur d'implantation $e_4 \simeq 0,6\mu m$. Il est recherché d'obtenir un dopage constant supérieur à $10^{17}.cm^{-3}$, sur une grande profondeur, car cette couche est destinée à recevoir le contact ohmique de type-n de la photodiode $\Delta$. La conductivité $n^{++}$ permet de réaliser une faible résistance d'accès entre le contact ohmique et la photodiode. De plus, l'épaisseur $e_4$ formée permet d'éviter une sensibilité de cette couche 4 au léger redécapage qui se produit occasionnellement lors du début de croissance épitaxiale de la couche qui viendra la couvrir dans une étape ultérieure. La couche implantée 4 subit un recuit d'implantation dans un réacteur d'épitaxie à une température de l'ordre de 700°C pendant environ 1 heure sous pression partielle de phosphine ($PH_3$) et d'arsenic ($As_2$). Cependant, avant de pratiquer ce recuit, la couche MK2 en photorésist est éliminée.

Dans le cas où le puits 51 présente un de ses flancs en pente douce, la couche MK2 en photorésist est éliminée sur une zone adjacente à ce flanc et la couche MK1 diélectrique peut être conservée dans cette région. L'implantation ionique est alors pratiquée dans l'ouverture ainsi réalisée dans la couche MK2, éventuellement à travers MK1, et il en résulte une couche 4 de type de conductivité $n^{++}$ qui s'étend non seulement au fond du puits, mais encore sur le flanc en pente douce et sur le bord adjacent. Le recuit d'implantation est ensuite pratiqué comme il a été dit précédemment.

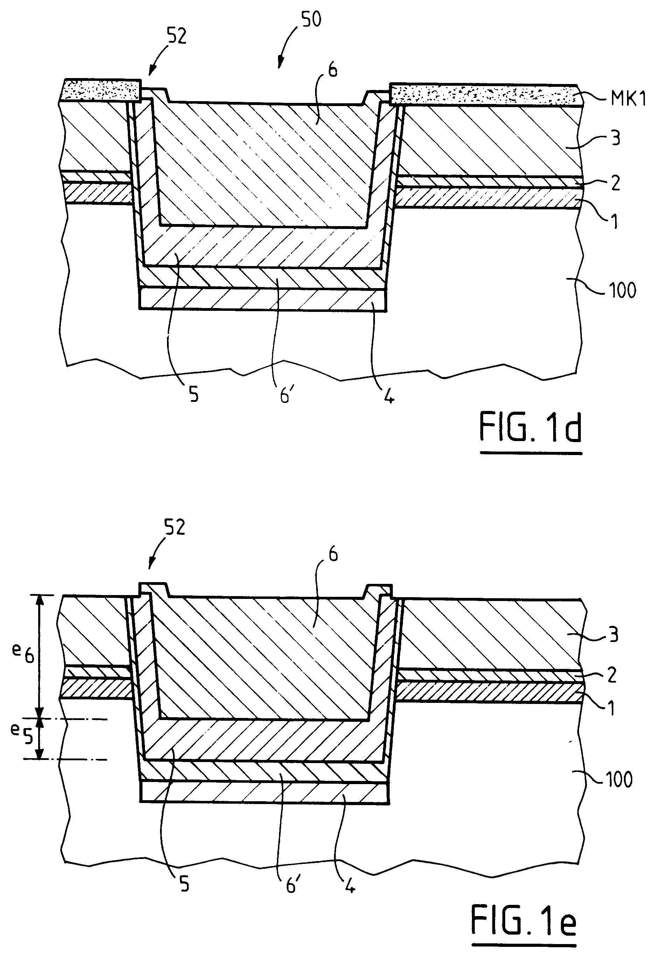

h') croissance épitaxiale localisée par le masque MK1, dans le puits 51 dans ce même réacteur d'épitaxie, en surface de la couche implantée 4, d'une couche 6' d'arséniure de gallium et d'indium (GaInAs) d'épaisseur environ 0,1 $\mu m$. Cette couche n'est pas obligatoire, mais permettra dans une étape ultérieure d'arrêter automatiquement la gravure des couches à un niveau voulu. Elle n'est pas dopée intentionnellement et montre un dopage résiduel d'environ $2.10^{15} cm^{-3}$ (voir la figure 1d en coupe). L'échantillon n'est pas déplacé du réacteur entre l'étape h et les étapes de croissance épitaxiale ultérieures.

Le choix du type de technologie pour la croissance épitaxiale des couches formant la photodiode $\Delta$ dans le puits 51, s'est porté sur la méthode aux chlorures en phase vapeur. Il existe en effet d'autres méthodes de croissance épitaxiale; par exemple la méthode dite MBE ou méthode d'épitaxie par jet moléculaire, mais à ce jour la croissance du matériau InP est difficile par cette méthode, ou par exemple la méthode dite LPE ou épitaxie en phase liquide, mais l'épaisseur des couches est difficile à contrôler par cette méthode. Au contraire la méthode aux chlorures en phase vapeur (VPE) permet d'obtenir des couches d'une grande pureté, d'épaisseur bien contrôlée, et permet d'obtenir que la croissance ne se produise pas sur le masque MK1 en diélectrique, par exemple en silice ($SiO_2$), d'où il résulte que l'on obtiendra spontanément à l'issue de la réalisation ainsi localisée des différentes couches de la diode, un dispositif pratiquement planaire. La gravure prévue par le procédé connu de l'état de la technique sera donc superflue. On verra seulement apparaître en bordure de l'ouverture du puits un léger bourrelet 52 de l'ordre de 3 $\mu m$.

Pendant cette étape h' et l'étape suivante i, la couche protectrice MK1 en diélectrique est conservée. Toutes les couches épitaxiales sont réalisées à la suite les unes des autres et du recuit de l'étape h dans le même réacteur.

i) croissance épitaxiale, par la même méthode, en surface de la couche 6' ou 4, d'une couche 5 de phos-phure d'indium de type n (InP-n) d'épaisseur $e_5 \simeq 2$ $\mu m$, puis d'une couche 6 en arséniure de gallium et d'indium ($Ga_{0,47}In_{0,53}As$) de type n, d'épaisseur $e_6$ telle que 3 $\mu m \leq e_6 \leq 3,5$ $\mu m$, l'épaisseur $e_6$ étant environ la différence entre $e_{51}$ et $e_5$. Ces couches ne sont pas dopées intentionnellement. La couche 5 d'InP présente un dopage résiduel de l'ordre de $10^{14}$ à $10^{15}.cm^{-3}$ et la couche 6 de GaInAs un dopage résiduel de l'ordre de $2.10^{15}.cm^{-3}$ (voir figure 1d en coupe). A l'issue de cette croissance le masque MK1 est éliminé (voir figure 1e en coupe). On a ainsi réalisé une hétérostructure InP/GaInAs, comme montré sur la figure 1d.

Mais il est souvent souhaitable pour améliorer les performances de la diode, de réaliser une double hétérostructure InP/GaInAs/InP. Selon l'invention cette réalisation est aisée. On réalisera dans ce cas la couche 6 d'arséniure de gallium et d'indium GaInAs d'épaisseur 2 $\mu m \leq e_6 \leq 2,5$ $\mu m$ suivie d'une couche de phosphure d'indium InP d'épaisseur $e_5' \simeq 1$ $\mu m$ également avec son taux de dopage résiduel.

A l'issue de cette croissance le masque MK1 est éliminé.

Toutefois si une région 4 implantée $n^{++}$ a été réalisée sur un bord du puits alors cette région est protégée par exemple par une couche diélectrique de nitrure de silicium $Si_2N_4$ jusqu'à la réalisation de la métallisation de contact n.

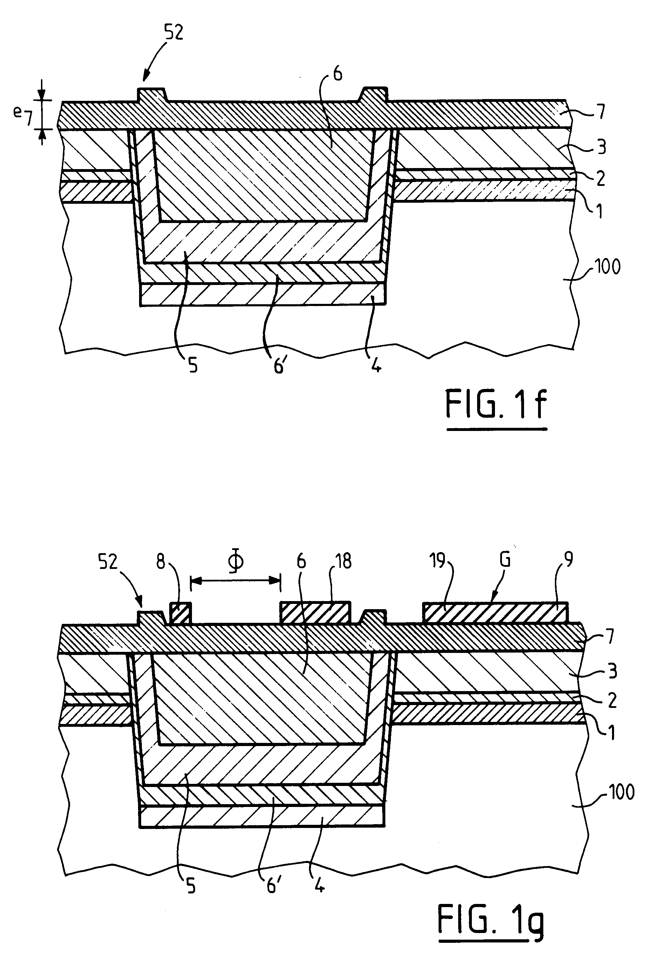

j) réalisation en surface du dispositif total, d'une couche 7 de type de conductivité $p^+$. Cette couche est obtenue ici par diffusion d'atomes Zn. Cette diffusion est effectuée en ampoule semi-ouverte, à 530°C, au moyen par exemple de vapeur de $ZnAs_2$, pendant environ 10mn. Cette couche 7 de type $p^+$ est destinée à réaliser les contacts de type p des jonctions p-n de la photodiode $\Delta$ et du transistor T J-FET. L'épaisseur de diffusion pour réaliser la couche 7 est favorablement $e_7 \simeq 0,3\mu m$ à $0,7\ \mu m$ dans le matériau GaInAs. (voir la figure 1f qui correspond au cas d'une diode à simple hétérostructure). Lorsque la diode comporte une double hétérostructure, et donc une couche supérieure 5' d'InP, la diffusion étant plus rapide dans l'InP, la couche 7 de type p atteindra alors une profondeur de l'ordre de 1 à $1,4\ \mu m$ dans la structure de diode.

k) réalisation en surface de la couche 7 de type $p^+$, du contact 8 de type p de la photodiode $\Delta$, contact qui sera de préférence en forme d'anneau (voir les figures 1g en coupe selon l'axe I-I de la figure 5 vue du dessus) muni d'un plot 18 pour la connexion, et du contact 9 de grille G du transistor J-FET, grille qui pourra être par exemple :

de largeur $\ell_g \simeq 250\ \mu m$

de longueur $L_G \simeq 1\ \mu m$

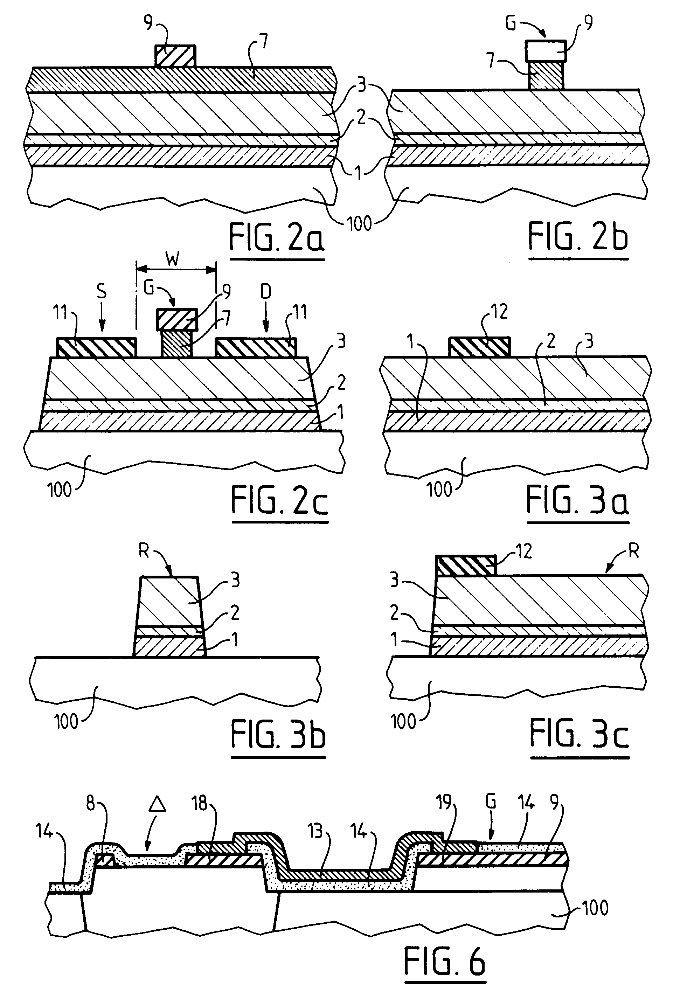

et munie d'un plot 19 pour la connexion. Le diamètre de l'anneau 8 sera favorablement $\phi \simeq 80\ \mu m$ (voir les figures 1g et 2a en coupe et 5 vue du dessus. Le contact en forme d'anneau délimite la région de la diode $\Delta$ qui reçoit l'illumination.

La métallisation pour réaliser les couches 8, 18, 9, 19 sera de préférence une multicouche de Ti/Pt/Au déposée dans cet ordre avec des épaisseurs respectives de 50 nm pour Ti, 70 nm pour Pt et 150 nm pour Au. Ce dépôt est suivi d'un recuit de l'ordre de 420°C sous atmosphère de $H_2$ ou $N_2$ pendant environ 2 mn. Le dépôt est fait dans l'ouverture d'un masque par exemple de photorésist qui est ensuite éliminé.

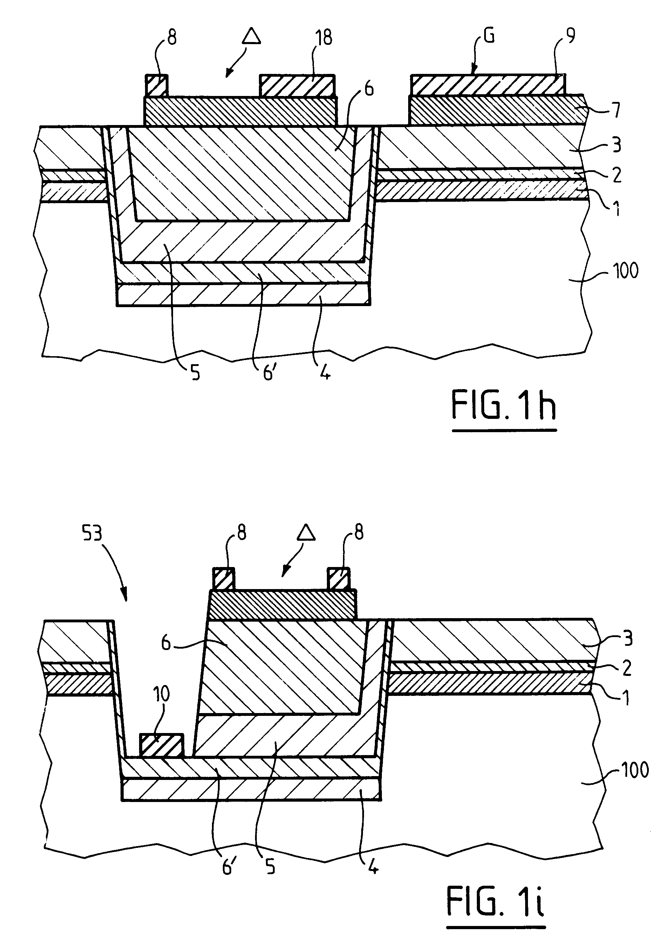

l) Gravure pour éliminer la couche 7 de type p dans toutes les régions du dispositif à l'exclusion de la région de diode $\Delta$ et de grille G du transistor (voir la figure 1h montrant en coupe selon l'axe I-I de la figure 5 la diode $\Delta$ et la grille G du transistor dans un exemple de réalisation, et la figure 2b montrant en coupe selon l'axe III-III de la figure 5 la grille G du transistor à l'issue de cette étape). Cette gravure est réalisée en utilisant les contacts ohmiques 9 et 19 comme masques et un masque couvrant l'ensemble de la diode $\Delta$, par une méthode par exemple chimique. La gravure est arrêtée au niveau supérieur de la couche 3 de GaInAs de type $n^+$. Un mélange chimique pour effectuer cette gravure peut être constitué d'acide citrique $+ H_2O_2$.

m) ouverture dans une région située en bordure externe de l'anneau 8, mais à l'intérieur de la région présentant les bourrelets 52 précédemment définis, d'un puits par une méthode de gravure sélective, par exemple chimique, jusqu'au niveau supérieur de la couche 6' en GaInAs non dopé. Durant cette gravure, l'ensemble du circuit en cours d'élaboration est protégé par un masque. La couche 6 en GaInAs est gravée en premier lieu, par exemple au moyen du mélange déjà cité de 4 $H_2SO_4$ + 1$H_2O_2$ + 10 $H_2O$. Puis la gravure de la couche 5 d'InP est pratiquée par exemple au moyen du mélange de 1HCl + 1$H_3$ $PO_4$. Ces mélanges chimiques permettant d'obtenir les gravures des matériaux GaInAs et InP sélectivement, la gravure du puits 53 s'arrête automatiquement à la surface supérieure de la couche de GaInAs 6', si elle existe. Cette couche 6' joue le rôle de couche d'arrêt, c'est pourquoi elle est d'un grand intérêt. Le but est de dégager le fond du puits 53 pour établir un contact ohmique de type n avec la couche 4 d'InP de type $n^{++}$. La couche d'arrêt 6' peut être conservée, elle ne gêne pas l'établissement de ce contact ohmique du fait de sa faible épaisseur (voir la figure 1i en coupe selon l'axe II-II de la figure 5).

Dans le cas où la couche 4 de type $n^{++}$ a été réalisée sur un des flancs et un des bords externes du puits 51, alors l'ouverture 53 n'est pas pratiquée et le contact ohmique de type n pourra être réalisé après élimination de la protection $SI_3N_4$ en surface du dispositif dans la région réservée.

n) réalisation des contacts ohmiques de type n dans les ouvertures d'un masque, ces ouvertures dégageant

- l'emplacement du plot 10 en surface de la couche 4 éventuellement dans le puits 53 (contact de type n de la diode $\Delta$ (voir la figure 1i)) ou dans la région réservée en bordure du puits.
- l'emplacement des zones 11 de part et d'autre de la grille G du transistor T, pour constituer les contacts de source S et drain D du transistor T, en surface de la couche 3 de GaInAs de type n (voir la figure 2c en coupe selon l'axe III-III de la figure 5)
- l'emplacement des zones 12 constituant les extrémités de la résistance de charge R du transistor T en surface également de la couche 3 de GaInAs-n (voir la figure 3c en coupe selon l'axe IV-IV de la figure 5 vue du dessus).

Ces contacts ohmiques de type n sont réalisés par une métallisation composée d'un alliage de Au-Ge surmonté d'une couche de Ni. Le masque est ensuite éliminé. L'alliage du contact ohmique se fait en portant le dispositif à une température d'environ 410°C sous $H_2$ pendant environ 1 mn.

Si les couches 7, 3, 2 constituant la structure du transistor T ont été réalisées avec les épaisseurs les plus grandes des fourchettes données, alors l'épaisseur du plot de grille 7 est suffisante pour permettre la mise en oeuvre d'un procédé d'autoalignement. En effet lors de la gravure de la couche 7 autour de la métallisation de grille 9 servant de masque, il se produit une gravure latérale, dite sous-gravure du même ordre de grandeur que la gravure verticale. Si l'épaisseur du plot de grille 7 est suffisante, les métallisations 11 de source S et de drain D peuvent être effectuées en utilisant les bords de la métallisation 9 de grille comme masque. Les performances d'un transistor dont les électrodes sont ainsi autoalignées sont plus grandes du fait que la longueur de grille est diminuée. On peut atteindre ainsi des longueurs de grille submicroniques.

Dans le cas où les épaisseurs des couches de la structure du transistor sont choisies faibles, les zones 11 de source et drain sont réalisées par simple alignement et espacées d'une distance W ≃ 4 $\mu$m.

o) gravure, autour de la diode Δ, autour du transistor T, autour du dessin prévu pour la résistance R, successivement des couches 3, 2 et 1 pour faire apparaître la surface du substrat. Durant cette opération de gravure, la diode Δ, le transistor T et la résistance R sont protégés par un masque. Cette opération est destinée à former des MESA pour isoler la diode Δ et le transistor T, et à délimiter la région résistive constituant la résistance R. Cette gravure peut être effectuée chimiquement dans les conditions citées au cours des étapes précédentes. Le masque est ensuite éliminé.

Le dessins de la résistance R est prévu, par calcul qui donne la valeur de la résistance en fonction de la longueur de cette résistance, de l'épaisseur et de la largeur du matériau résistif (ici GaInAs type n) et de sa résistivité, laquelle est fonction de la concentration en porteurs. On peut ainsi obtenir, selon le tracé défini, des résistances de 50 Ω à 100 kΩ en fonction du circuit souhaité (voir la figure 1j en coupe selon l'axe I-I, la figure 1k en coupe selon l'axe II-II pour la diode Δ ; voir la figure 2c en coupe selon l'axe III-III pour le transistor T ; voir la figure 3b en coupe selon l'axe III-III et la figure 3c en coupe selon l'axe IV-IV pour la résistance).

p) réalisation d'une couche diélectrique 14, favorablement en silice ($SiO_2$) sur l'ensemble du dispositif, en ménageant des ouvertures sur :
- une zone M destinée à constituer un plot de masse,
- la région 10 de contact type n de la diode,
- la région 18 de contact de type p de la diode,
- le plot 19 de contact de grille du transistor,
- les régions 11 de source et drain du transistor,
- les régions 12 des deux extrémités de la résistance R,
- éventuellement une zone pour constituer un plot d'alimentation en tension continue $V_{DD}$,
- éventuellement une zone pour constituer un plot de sortie S du signal disponible sur le drain D (voir la figure 6 qui montre en coupe l'interconnexion entre le contact p de la diode et celui de grille du transistor)

q) réalisation des métallisations d'interconnexion 13 pour relier :
- une extrémité de la résistance R au plot 19 du transistor et au plot 18 de la diode,
- l'autre extrémité de la résistance R à la source et à la masse M, dont la région est métallisée par la même opération,
- le drain au plot de sorties dont la région est métallisée par la même opération,
- le plot 10 de la diode au plot $V_{DD}$ d'alimentation dont la région est métallisée par la même opération,

Cette métallisation d'interconnexion est réalisée dans les ouvertures d'un masque qui découvrent, d'une part les mêmes régions que la couche de diélectrique 14, et d'autre part le dessin des lignes d'interconnexion. Après la réalisation de ces interconnexions, ce masque est éliminé entraînant par LIFT-OFF le métal déposé hors des plots et des lignes d'interconnexions.

Mais la couche de diélectrique 14 est conservée comme couche de protection. Elle sert aussi de couche antireflet sur la zone photosensible de la diode.

La métallisation 13 d'interconnexion est favorablement un multicouche Ti/Pt/Au telle que déjà décrite.

L'interconnexion 13 du plot 18 de la diode et du plot 19 de la grille du transistor est illustrée par la figure 6 en coupe selon l'axe I-I.

Les tableaux I et II regroupent les caractéristiques des couches et contacts du dispositif selon l'invention.

Pour les applications au domaine de la détection infrarouge les couches 2, 3, 6, et 6' peuvent être en différents matériaux III-V de composition $Ga_xIn_{1-x}As_yP_{1-y}$ dans laquelle x et y designent les proportions des éléments respectifs.

Cette composition est choisie de façon connue en soi en fonction de la longueur d'onde de fonctionnement du dispositif, tout en recherchant l'accord de maille entre ces matériaux et InP.

**TABLEAU I**

| Réf. | Méthode d'élaboration | Composition | Type de conductivité | Taux de dopage | Agents dopants | Epaisseur en µm |
|---|---|---|---|---|---|---|
| 100 | Substrat | InP | S.I | $\approx 10^{14} cm^{-3}$ | Cr(ion) | $e_1 < 0,2$ |
| 1 | Epitaxie | InP | $n$ | $\approx 2.10^{15} cm^{-3}$ | N.I | $0,5 < e_2 < 0,6$ |
| 2 | Epitaxie | GaInAs | $n$ | $\approx 10^{17} cm^{-3}$ | N.I | $0,4 < e_3 < 0,5$ |
| 3 | Implantation | GaInAs | $n^+$ | $> 10^{17} cm^{-3}$ | Si28(ion) | $e_4 \approx 0,6$ |
| 4 | Implantation | InP | $n^{++}$ | $\approx 2.10^{15} cm^{-3}$ | Si28(ion) | $e_6' \approx 0,1$ |
| 6' | Epitaxie | GaInAs | $n$ | $\approx 10^{14} cm^{-3}$ | N.I | $e_5 \approx 2$ |
| 5 | " | InP | $n$ | " | N.I | $e_5' \approx 1$ |
| 5' | " | " | $n$ | $\approx 2.10^{15} cm^{-3}$ | N.I | $2 < e_6 < 3,5$ |
| 6 | " | GaInAs | $n$ | | N.I | $0,3 < e_7 < 0,7$ |
| 7 | Diffusion | GaInAs | $p^+$ | | Zn(atome) | |

**Abréviations :** Ref. = Référence de la couche ou élément

S.I. = Semi-isolant

N.I. = Non intentionnel

9

| TABLEAU II | | |
|---|---|---|
| Réf. | Composition | Type de contact |
| 8, 18, 9, 19 | Ti/Pt/Au | Ohmique type p |
| 10, 11, 12 | Au-Ge/Ni | Ohmique type n |
| 13, M | Ti/Pt/Au | Interconnexions |

## Revendications

1. Procédé de réalisation d'un circuit intégré pour la détection du rayonnement infrarouge comprenant un substrat semi-isolant (100) muni d'une photodiode PIN (Δ) enterrée, d'un transistor à effet de champ à jonction J-FET (T) dont la grille est connectée à la photodiode PIN, et une résistance (R) connectée au transistor, ce procédé incluant la gravure d'un puits (51) dans le substrat semi-isolant, la croissance sur au moins une partie de la surface du substrat semi-isolant d'une première structure (1, 2, 3) de couches épitaxiales de matériaux semiconducteurs dans laquelle est formé le transistor J-FET, et la croissance d'une seconde structure (5, 6, 6') de couches épitaxiales de matériaux semiconducteurs dans laquelle est formée la diode PIN, caractérisé en ce que la gravure du puits est réalisée après croissance sur toute la surface du substrat semi-isolant de la première structure de couches épitaxiales et est pratiquée à travers cette structure jusque dans le substrat, et en ce que la croissance de la seconde structure de couches épitaxiales est localisée dans ledit puits, la surface supérieure de ladite seconde structure étant coplanaire avec celle de la première structure de couches.

2. Procédé selon la revendication 1, caractérisé en ce que la croissance épitaxiale des couches de la première structure et des couches de la seconde structure est réalisée sans dopage autre que le dopage résiduel de croissance et en ce que les régions de type de conductivité n et p du transistor et de la diode sont obtenues par une méthode choisie entre l'implantation et la diffusion d'espèces appropriées à l'obtention du type de conductivité n et p respectivement.

3. Procédé selon la revendication 2, caractérisé en ce qu'une implantation ionique d'espèces propres à obtenir le type de conductivité n est pratiquée de façon localisée, au moins sur le fond du puits, dans le matériau du substrat, avant la croissance de la seconde structure de couches épitaxiales, une couche de contact (4) de type $n^{++}$ pour la diode PIN étant ainsi réalisée, et en ce que le recuit de cette implantation est réalisé dans la chambre du réacteur utilisée pour la croissance épitaxiale de cette seconde structure de couches, sous atmosphère contrôlée.

4. Procédé selon la revendication 3, caractérisé en ce que cette implantation localisée s'étend aussi sur l'un des flancs du puits et sur une zone bordant le puits.

5. Procédé selon l'une des revendications 3 ou 4, caractérisé en ce que la formation de la première structure de couches épitaxiales comprend la croissance sur un substrat en InP semi-isolant, d'une couche épitaxiale (2,3) de composition $Ga_xIn_{1-x}As_yP_{1-y}$ dans laquelle x et y désignent des proportions, non dopée intentionnellement lors de la croissance et cette couche est soumise après la croissance à une implantation ionique d'espèces propres à obtenir le type de conductivité n sur une profondeur $e_3$ inférieure à son épaisseur $e_2$, laquelle implantation est suivie d'un recuit dans la chambre du réacteur d'épitaxie sous atmosphère contrôlée, la couche active du transistor J-FET et la résistance (R) étant ainsi formées.

6. Procédé selon la revendication 5, caractérisé en ce que la formation de la première structure de couches comprend la croissance entre le substrat et la couche de $Ga_xIn_{1-x}As_yP_{1-y}$, d'une couche épitaxiale (1) en InP formant une couche tampon.

7. Procédé selon l'une des revendications 5 ou 6, caractérisé en ce que la formation de la seconde structure de couches épitaxiales comprend la réalisation d'une hétéro-structure de matériaux III-V, incluant la croissance d'une première couche d'InP (5) suivie de la croissance d'une couche (6) de composition $Ga_xIn_{1-x}As_yP_{1-Y}$ dans laquelle x et y désignent des proportions, ces couches, localisées dans le puits, étant non dopées intentionnellement, et formant la région n de la diode PIN.

8. Procédé selon l'une des revendications 5 ou 6, caractérisé en ce que la formation de la seconde structure de couches épitaxiales comprend la réalisation d'une double hétérostructure de matériaux III-V, incluant la croissance d'une première couche (5) d'InP, suivie de la croissance d'une couche (6) de $Ga_xIn_{1-x}As_yP_{1-y}$ dans laquelle x et y désignent des proportions, puis de la croissance d'une seconde couche d'InP, ces couches, localisées dans le puits, étant non dopées intentionnellement et formant la région n de la diode PIN.

9. Procédé selon l'une des revendications 7 ou 8, caractérisé en ce que la formation de la seconde structure de couches épitaxiales comprend la croissance localisée dans le puits, avant la croissance de la première couche d'InP, d'une couche (6') de $Ga_xIn_{1-x}As_yP_{1-y}$ non dopée intentionnellement, formant une couche tampon et éventuellement une couche d'arrêt de gravure.

10. Procédé selon l'une des revendications 7 à 9, caractérisé en ce qu'une diffusion d'espèces propres à obtenir le type de conductivité p, formant une couche diffusée (7), est réalisée de façon non localisée dans la partie supérieure de la première structure de couches et de la deuxième structure de couches à l'exclusion toutefois de la couche (4) de type $n^{++}$ lorsqu'elle apparaît en surface, sur une profondeur $e_7$ inférieure à l'épaisseur $e_3$ de la couche (3) formée par implantat de la première structure et supérieure ou égale à l'épaisseur $e_5'$ de la seconde couche épitaxiale d'InP de la seconde structure lorsque cette couche existe, la région p de la diode PIN et la grille du transistor J-FET étant ainsi formées.

11. Procédé selon la revendication 10, caractérisé en ce que des métallisations ohmiques (8, 18, 9, 19) de type p sont réalisées en surface de la couche diffusée (7) de type p dans les régions respectives de la seconde et de la première structure de couches, le contact de type p de la diode PIN et l'électrode de grille du transistor J-FET étant ainsi réalisés.

12. Procédé selon la revendication 11, caractérisé en ce que le contact (8, 18) de type p de la diode est réalisé sous la forme d'un anneau (8) muni d'un plot (18) et l'électrode de grille (9, 19) du transistor sous la forme d'un doigt (9) muni d'un plot (19).

13. Procédé selon la revendication 12, caractérisé en ce que la couche diffusée de type p est éliminée du dispositif par gravure autour des contacts ohmiques de type p servant de masques et à l'exclusion de la région centrale de l'anneau qui est conservée au moyen d'une couche de protection durant la gravure.

14. Procédé selon la revendication 13, caractérisé en ce que la gravure de la couche p occasionne sous les métallisations de contact ohmique -p servant de masque une gravure latérale dite sous-gravure.

15. Procédé selon la revendication 14, caractérisé en ce que lorsque la couche $n^{++}$ (4) n'apparaît pas en surface une gravure est pratiquée dans les couches de la seconde structure en dehors de la couche diffusée (7) de type p, une zone de la couche de contact de type $n^{++}$ étant ainsi découverte, cette gravure étant éventuellement arrêtée par la couche (6') d'arrêt de gravure lorsqu'elle existe.

16. Procédé selon la revendication 15, caractérisé en ce que des métallisations ohmiques (10, 11, 12) de type n sont réalisées en surface de la couche n de la première structure de couches et en surface de la couche $n^{++}$ de la seconde structure, le contact (10) de type n de la diode PIN, les électrodes (11) de source et drain du transistor et les extrémités (12) de la résistance R étant ainsi réalisés.

17. Procédé selon la revendication 16, caractérisé en ce que les bords latéraux de la métallisation de type p de l'électrode de grille servent de masques lors de la réalisation des métallisations de type n de source et drain du transistor selon une méthode dite d'autoalignement utilisant les sous-gravures et permettant d'éviter les courts-circuits entre électrodes.

18. Procédé selon la revendication 17, caractérisé en ce qu'à l'issue de la formation des métallisations de type n, une gravure des couches est pratiquée autour des éléments susmentionnés ($\Delta$, T, R) du circuit intégré jusqu'à la surface supérieure du substrat, des MESAS d'isolement autour de la diode et du transistor étant ainsi formées et la surface de la résistance R entre ses métallisations d'extrémités étant ainsi délimitée.

19. Procédé selon la revendication 18, caractérisé en ce qu'à l'issue de cette gravure, il comprend le dépôt d'une couche diélectrique (14) sur la surface du dispositif incluant la surface de la région interne du contact de type p en anneau de la diode, dite région d'éclairement, et excluant les plots de contacts électrique de la diode, du transistor, les extrémités de la résistance R, ainsi que des zones prévues sur le substrat pour réaliser des contacts de masse, et d'alimentation en continu, une couche de protection pour le dispositif et une couche antireflet pour la région d'éclairement étant ainsi formée.

20. Procédé selon la revendication 19, caractérisé en ce qu'il comprend en outre une étape de formation, en surface de la couche diélectrique de protection, de rubans de métallisation (13) reliant un plot d'extrémité de la résistance R au plot de grille du transistor et au plot de contact p de la diode, reliant le plot de seconde extrémité de la résistance R à la source S du transistor et à un plot de masse M, et reliant le plot de contact n de la diode à un plot d'alimentation continue $V_{DD}$.

21. Procédé selon l'une des revendications précédentes caractérisé en ce que les proportions du composé $Ga_xIn_{1-x}As_yP_{1-y}$ sont :
x = 0,47
y = 1.

22. Procédé selon l'une des revendications précédentes, caractérisé en ce que le matériau InP est dopé au Cr, le substrat semi-isolant étant ainsi obtenu, en ce qu'on implante dans la couche de GaInAs des ions $Si^{28}$ à une concentration de l'ordre de $10^{17}.cm^{-3}$, la couche (3) de type $n^+$ étant ainsi obtenue, en ce qu'on implante dans le matériau InP du fond du puits des ions $Si^{28}$ à une concentration de l'ordre de $10^{17}$ $cm^{-3}$, la couche (4) de type $n^{++}$ étant ainsi obtenue, en ce qu'on diffuse dans la couche GaInAs des atomes de Zn, la couche diffusée (7) de type $p^+$ étant ainsi obtenue.

23. Procédé selon la revendication 22, caractérisé en ce que la diffusion d'atomes de Zn est obtenue en ampoule semi-ouverte, à 530°C, au moyen de vapeurs de ZnAs2, pendant environ 10 mn.

24. Procédé selon l'une des revendications précédentes, caractérisé en ce que les couches épitaxiales sont réalisées par épitaxie en phase vapeur aux chlorures avec leur taux de dopage résiduel (VPE).

25. Procédé selon l'une des revendications 11 à 24, caractérisé en ce que les contacts ohmiques de type-p sont formés d'une multicouche Ti/Pt/Au, les contacts ohmiques de type-n sont formés du composé Au-Ge recouvert d'une couche de Ni et recuit pour former l'alliage et les interconnexions entre éléments et le plot de masse M sont formés d'une multicouche Ti/Pt/Au.

26. Procédé selon l'une des revendications 22 à 25, caractérisé en ce que le recuit d'implantation des ions permettant d'obtenir la couche n de la première structure est pratiqué à environ 700°C pendant environ 15 mn sous pression partielle d'arsine ($AsH_3$) et que le recuit d'implantation d'ions dans le puits permettant d'obtenir la couche $n^{++}$ est pratiqué à environ 700°C pendant environ 1h sous pression partielle de phosphine ($PH_3$) et d'arsenic (As2) dans le réacteur d'épitaxie.

27. Procédé selon l'une des revendications précédentes, caractérisé en ce que dans la mesure où ces couches existent, leurs épaisseurs sont données par (en $\mu$m).
a) dans la première structure
épaisseur de la couche tampon:
$e_1 \leqq 0,2$

épaisseur de la couche épitaxiale GaInAs:

$0,5 \leq e_2 \leq 1\mu m$

profondeur d'implantation de type n dans la couche épitaxiale en GaInAs:

$0,4 \leq e_3 \leq 0,9$

profondeur de diffusion de type p dans la couche en GaInAs:

$0,3 \leq e_7 \leq 0,7$

b) dans la seconde structure

profondeur d'implantation de type $n^{++}$ dans le puits:

$e_4 \simeq 0,6$

épaisseur de la couche de GaInAs tampon et arrêt:

$e_6 \simeq 0,1$

épaisseur de la première couche d'InP:

$e_5 \simeq 2$

épaisseur de la couche de GaInAs:

$2 \leq e_6 \leq 3,5$

épaisseur de la seconde couche d'InP:

$e_5' \simeq 1$

profondeur du puits recevant la seconde structure:

$5 \ \mu m \leq e_{51} \leq 5,5 \ \mu m$.

**Claims**

1. A production method of an integrated circuit for the detection of infrared radiation, comprising a semi-insulating substrate (100) provided with a buried PIN photodiode (Δ), with a junction field effect transistor or J-FET (T) whose gate is connected to the PIN photodiode, and with a resistor (R) connected to the transistor, which process includes etching of a well (51) into the semi-insulating substrate the growth on at least a portion of the surface of the semi-insulating substrate of a first structure (1, 2, 3) of epitaxial layers of semiconductor materials in which the J-FET transistor is formed, and the growth of a second structure (5, 6, 6') of epitaxial layers of semiconductor materials in which the PIN diode is formed, characterized in that the etching of the well is realised after the growth over the entire surface of the semi-insulating substrate of the first structure of epitaxial layers and is effected through this structure into the substrate, and in that the growth of the second structure of epitaxial layers is localized in said well, the upper surface of said second structure being coplanar with that of the first layer structure.

2. A method as claimed in Claim 1, characterized in that the epitaxial growth of the layers of the first structure and of the layers of the second structure is realised without doping other than the residual doping of the growth, and in that the regions of n- and p-type conductivity of the transistor and of the diode are obtained by a method chosen between implantation and diffusion of impurities suitable for obtaining the conductivity of the n- and p-type, respectively.

3. A method as claimed in Claim 2, characterized in that an ion implantation of impurities suitable for obtaining the n-type conductivity is carried out locally into the material of the substrate, at least at the bottom of the well, before the growth of the second structure of epitaxial layers, whereby a contact layer (4) of the $n^{++}$ type is realised for the PIN diode, and in that the heat treatment for this implantation is carried out in the reactor chamber used for the epitaxial growth of said second structure of layers in a controlled atmosphere.

4. A method as claimed in Claim 3, characterized in that said local implantation also extends over one of the flanks of the well and over a zone adjoining the well.

5. A method as claimed in one of the Claims 3 and 4, characterized in that the formation of the first structure of epitaxial layers comprises the growth on a substrate of semi-insulating InP of an epitaxial layer (2, 3) of the composition $Ga_xIn_{1-x}As_yP_{1-y}$ in which x and y designate proportional quantities, which epitaxial layer is not intentionally doped during the growth and after the growth is submitted to an ion implantation of impurities suitable for obtaining the n-type conductivity to a depth $e_3$ smaller than its thickness $e_2$, which implantation is followed by a heat treatment in the epitaxy reactor chamber in a controlled atmosphere, whereby the active layer of the transistor J-FET and the resistor (R) are formed.

**6.** A method as claimed in Claim 5, characterized in that the formation of the first structure of layers comprises the growth between the substrate and the layer of $Ga_xIn_{1-x}As_yP_{1-y}$ of an epitaxial layer (1) of InP which forms a buffer layer.

**7.** A method as claimed in one of the Claims 5 and 6, characterized in that the formation of the second structure of epitaxial layers comprises the realisation of a heterostructure of III-V materials, including the growth of a first InP layer (5) followed by the growth of a layer (6) with the composition $Ga_xIn_{1-x}As_yP_{1-y}$ in which x and y designate proportional quantities, which layers are localized in the well, are not intentionally doped, and form the n-type region of the PIN diode.

**8.** A method as claimed in one of the Claims 5 and 6, characterized in that the formation of the second structure of epitaxial layers comprises the realisation of a double heterostructure of III-V materials, including the growth of a first InP layer (5), followed by the growth of a layer (6) of $Ga_xIn_{1-x}As_yP_{1-y}$ in which x and y designate proportional quantities, followed by the growth of a second InP layer, which layers are localized in the well, are not intentionally doped, and form the n-type region of the PIN diode.

**9.** A method as claimed in one of the Claims 7 and 8, characterized in that the formation of the second structure of epitaxial layers comprises the localized growth in the well, preceding the growth of the first InP layer, of a layer (6') of $Ga_xIn_{1-x}As_yP_{1-y}$ not intentionally doped, forming a buffer layer and, if applicable, an etching stopper layer.

**10.** A method as claimed in any one of the Claims 7 to 9, characterized in that a diffusion of impurities suitable for obtaining the p-type conductivity, forming a diffused layer (7), is realised in a non-localized manner in the upper portion of the first structure of layers and of the second structure of layers, but with the exclusion of the layer (4) of the $n^{++}$ type where the latter appears at the surface, to a depth $e_7$ smaller than the thickness $e_3$ of the layer (3) formed by implantation of the first structure and greater than or equal to the thickness $e_5$, of the second epitaxial InP layer of the second structure, if the latter layer exists, whereby the p-type region of the PIN diode and the gate of the J-FET transistor are formed.

**11.** A method as claimed in Claim 10, characterized in that p-type ohmic metallizations (8, 18, 9, 19) are realised at the surface of the p-type diffused layer (7) in the respective regions of the second and the first structure of layers, whereby the p-type contact of the PIN diode and the gate electrode of the J-FET transistor are realised.

**12.** A method as claimed in Claim 11, characterized in that the p-type contact (8, 18) of the diode is realised in the form of a ring (8) provided with a contact pad (18), and the gate electrode (9, 19) of the transistor is realised in the form of a finger (9) provided with a contact pad (19).

**13.** A method as claimed in Claim 12, characterized in that the p-type diffused layer is eliminated from the device by etching around the p-type ohmic contacts, which serve as masks, and with the exclusion of the central region of the ring which is conserved by means of a protective layer during the etching treatment.

**14.** A method as claimed in Claim 13, characterized in that the etching of the p-type layer causes a lateral etching, called underetching, under the p-type ohmic contact metallizations which serve as a mask.

**15.** A method as claimed in Claim 14, characterized in that, where the $n^{++}$ layer (4) does not appear at the surface, an etching is carried out into the layers of the second structure outside the p-type diffused layer (17), whereby a zone of the $n^{++}$-type contact layer is exposed, which etching is stopped, if applicable, by the etching stopper layer (6') if the latter exists.

**16.** A method as claimed in Claim 15, characterized in that ohmic n-type metallizations (10, 11, 12) are realised at the surface of the n-type layer of the first structure of layers and at the surface of the $n^{++}$-type layer of the second structure, whereby the n-type contact 10 of the PIN diode, the source and drain electrodes (11) of the transistor, and the ends (12) of the resistor R are realised.

17. A method as claimed in Claim 16, characterized in that the lateral edges of the p-type metallization of the gate electrode serve as masks during the provision of the n-type source and drain metallizations of the transistor by a so-called self-alignment method, which employs underetching and serves to avoid short-circuits between electrodes.

18. A method as claimed in Claim 17, characterized in that, at the end of the formation of the n-type metallizations, an etching of the layers is carried out around the above-mentioned elements ($\Delta$, T, R) of the integrated circuit down to the upper surface of the substrate, whereby insulating mesas are formed around the diode and the transistor and whereby the surface area of the resistor R between its end metallizations is delimited.

19. A method as claimed in Claim 18, characterized in that at the end of said etching treatment, the method comprises the deposition of a dielectric layer (14) on the surface of the device, including the surface of the internal region of the p-type annular contact of the diode, called illumination region, and excluding the electrical contact pads of the diode, of the transistor, the ends of the resistor R, and the zones provided on the substrate for realising the earth contacts and the DC-supply contacts, whereby a protective layer for the device and an anti-reflection layer for the illumination region are formed.

20. A method as claimed in Claim 19, characterized in that it comprises in addition a step of forming metallization strips (13) at the surface of the dielectric protective layer connecting an end contact pad of the resistor R to the gate connection of the transistor and to the p-type contact pad of the diode, connecting the second end contact of the resistor R to the source S of the transistor and to an earth connection M, and connecting the n-type contact pad of the diode to a DC-supply connection $V_{DD}$.

21. A method as claimed in any one of the preceding Claims, characterized in that the proportional quantities of the compound $Ga_xIn_{1-x}As_yP_{1-y}$ are:

$x = 0.47$

$y = 1.$

22. A method as claimed in any one of the preceding Claims, characterized in that the InP material is doped with Cr, whereby the semi-insulating substrate is obtained, in that $Si^{28}$ ions are implanted into the GaInAs layer with a concentration of the order of $10^{17}.cm^{-3}$, whereby the $n^+$ layer (3) is obtained, in that $Si^{28}$ ions are implanted into the InP material of the bottom of the well with a concentration of the order of $10^{17}.cm^3$, whereby the $n^{++}$ layer (4) is obtained, and in that Zn atoms are diffused into the GaInAs layer, whereby the $p^+$ diffused layer (7) is obtained.

23. A method as claimed in Claim 22, characterized in that the diffusion of Zn atoms is obtained in a half-opened vessel at 530 °C by means of $ZnAs_2$ vapour during approximately 10 minutes.

24. A method as claimed in any one of the preceding Claims, characterized in that the epitaxial layers are realised by vapour phase epitaxy (VPE) which chlorides at their residual doping levels.

25. A method as claimed in any one of the Claims 11 to 24, characterized in that the p-type ohmic contacts are formed by a Ti/Pt/Au multilayer, the n-type ohmic contacts are formed by the compound Au-Ge covered by an Ni layer and heated for forming the alloy, and the interconnections between elements and the earth connection M are formed by a Ti/Pt/Au multilayer.

26. A method as claimed in any one of the Claims 22 to 25, characterized in that the heat treatment for the ion implantation which renders it possible to obtain the n-type layer of the first structure is carried out at approximately 700 °C for approximately 15 minutes under a partial arsine ($AsH_3$) pressure, and in that the heat treatment for the ion implantation into the well which renders it possible to obtain the $n^{++}$ layer is carried out at approximately 700 °C during approximately 1 h under a partial phosphine ($PH_3$) and arsenic ($As_2$) pressure in the epitaxy reactor.

27. A method as claimed in any one of the preceding Claims, characterized in that the thicknesses of the layers, in as far as they are present, are the following (in $\mu$m):

a) in the first structure

thickness of the buffer layer:

$e_1 \leqq 0.2$

thickness of the epitaxial GaInAs layer:

$0.5 \leqq e_2 \leqq 1 \ \mu m$

n-type implantation depth into the epitaxial GaInAs layer:

$0.4 \leqq e_3 \leqq 0.9$

p-type diffusion depth into the GaInAs layer:

$0.3 \leqq e_7 \leqq 0.7$

b) in the second structure:

$n^{++}$-type implantation depth into the well:

$e_4 \approx 0.6$

thickness of the GaInAs buffer and stopper layer:

$e_6 \approx 0.1$

thickness of the first InP layer:

$e_5 \approx 2$

thickness of the GaInAs layer:

$2 \leqq e_6 \leqq 3.5$

thickness of the second InP layer:

$e_{5'} \approx 1$

depth of well accommodating the second structure:

$5 \ \mu m \leqq e_{51} \leqq 5.5 \ \mu m$.

**Patentansprüche**

1. Verfahren zur Herstellung einer integrierten Schaltung zum Detektieren einer Infrarotstrahlung, die ein mit einer vergrabenen PIN-Fotodiode ($\Delta$) versehenes halbisolieren des Halbleitersubstrat (100), einen Sperrschicht-Feldeffekttransistor J-FET (T), dessen Gate mit der PIN-Fotodiode verbunden ist, und einen mit dem Transistor verbundenen Widerstand (R) umfaßt, wobei dieses Verfahren das Einätzen einer Wanne (51) in das Halbleitersubstrat, das Aufwachsen einer ersten Struktur (1, 2, 3) von Epitaxialschichten aus Halbleitermaterialien, in der der Transistor J-FET ausgebildet wird, auf mindestens einem Teil der Fläche des Halbleitersubstrats und das Aufwachsen einer zweiten Struktur (5, 6, 6') von Epitaxialschichten aus Halbleitermaterialien, in der die PIN-Diode ausgebildet wird, beinhaltet, dadurch gekennzeichnet, daß das Einätzen der Wanne nach dem Aufwachsen über die gesamte Fläche des Halbleitersubstrats der ersten Struktur von Epitaxialschichten erfolgt und durch diese Struktur hindurch bis in das Substrat ausgeführt wird, und daß das Aufwachsen der zweiten Struktur von Epitaxialschichten auf die Wanne beschränkt ist, wobei die obere Fläche der zweiten Struktur koplanar mit der der ersten Schichtenstruktur ist.

2. Verfahren nach Anspruch 1, dadurch gekennzeichnet, daß das epitaxiale Aufwachsen der Schichten der ersten Struktur und der Schichten der zweiten Struktur nur mit der Restdotierung des Aufwachsens durchgeführt wird und daß die Bereiche des Leitfähigkeitstyps n und p des Transistors und der Diode mit einem Verfahren hergestellt werden, das am besten geeignet ist, den Leitfähigkeitstyp n bzw. p zu erzielen, das heißt entweder durch Implantation oder Diffusion.

3. Verfahren nach Anspruch 2, dadurch gekennzeichnet, daß eine zum Erzielen des Leitfähigkeitstyps n geeignete Ionenimplantation lokal, zumindest auf dem Boden der Wanne, im Substratmaterial vor dem Aufwachsen der zweiten Struktur von Epitaxialschichten durchgeführt wird, wobei eine $n^{++}$-Kontaktschicht (4) für die PIN-Diode hergestellt wird, und daß das Ausheilen bei dieser Implantation in der für das epitaxiale Aufwachsen dieser zweiten Struktur von Schichten verwendeten Reaktorkammer in kontrollierter Atmosphäre erfolgt.

4. Verfahren nach Anspruch 3, dadurch gekennzeichnet, daß diese lokale Implantation sich auch auf eine der Wannenseiten und über eine an die Wanne angrenzende Zone erstreckt.

5. Verfahren nach einem der Ansprüche 3 oder 4, dadurch gekennzeichnet, daß die Ausbildung der ersten Struktur von Epitaxialschichten das Aufwachsen einer Epitaxialschicht (2, 3) aus $Ga_x In_{1-x} As_y P_{1-y}$, worin x und y die Anteile bezeichnen, die während des Aufwachsens unbeabsichtigt dotiert werden, auf einem Halbleitersubstrat aus InP umfaßt und diese Schicht nach dem Aufwachsen einer Ionenimplantation der Art, daß man den n-Leitfähigkeitstyp über eine Tiefe $e_3$, die kleiner ist als seine Dicke $e_2$,

erhält, unterzogen wird und auf diese Implantation ein Ausheilen in der Epitaxie-Reaktorkammer in einer kontrollierten Atmosphäre folgt, wodurch die aktive Schicht des J-FET-Transistors und der Widerstand (R) gebildet werden.

6. Verfahren nach Anspruch 5, dadurch gekennzeichnet, daß die Ausbildung der ersten Schichtenstruktur das Aufwachsen einer Epitaxialschicht (1) aus InP, die eine Pufferschicht darstellt, zwischen dem Substrat und der Schicht aus $Ga_xIn_{1-x}As_yP_{1-y}$ umfaßt.

7. Verfahren nach einem der Ansprüche 5 oder 6, dadurch gekennzeichnet, daß die Ausbildung der zweiten Struktur von Epitaxialschichten die Herstellung einer Heterostruktur aus den Materialien III-V umfaßt, die das Aufwachsen einer ersten Schicht aus InP (5), gefolgt vom Aufwachsen einer Schicht (6) der Zusammensetzung $Ga_xIn_{1-x}As_yP_{1-y}$, worin x und y die Anteile bezeichnen, beinhaltet, wobei diese lokalen Schichten in der Wanne nicht absichtlich dotiert werden und den n-Bereich der PIN-Diode bilden.

8. Verfahren nach einem der Ansprüche 5 oder 6, dadurch gekennzeichnet, daß die Ausbildung der zweiten Struktur von Epitaxialschichten die Herstellung einer doppelten Heterostruktur aus den Materialien III-V umfaßt, die das Aufwachsen einer ersten Schicht (5) aus InP, gefolgt vom Aufwachsen einer Schicht (6) aus $Ga_xIn_{1-x}As_yP_{1-y}$, worin x und y die Anteile bezeichnen, und danach das Aufwachsen einer zweiten Schicht aus InP beinhaltet, wobei diese lokalen Schichten in der Wanne nicht absichtlich dotiert werden und den n-Bereich der PIN-Diode bilden.

9. Verfahren nach einem der Ansprüche 7 oder 8, dadurch gekennzeichnet, daß die Ausbildung der zweiten Struktur von Epitaxialschichten das lokale Aufwachsen einer Schicht (6') aus $Ga_xIn_{1-x}As_yP_{1-y}$ in der Wanne, die nicht absichtlich dotiert wird und eine Pufferschicht und eventuell eine Ätzsperrschicht bildet, vor dem Aufwachsen der ersten Schicht aus InP umfaßt.

10. Verfahren nach einem der Ansprüche 7 bis 9, dadurch gekennzeichnet, daß eine nicht lokale Diffusion, die geeignet ist, den p-Leitfähigkeitstyp zu erzielen, wobei eine diffundierte Schicht (7) gebildet wird, im oberen Teil der ersten Schichten-struktur und der zweiten Schichtenstruktur stattfindet, jedoch nicht in der $n^{++}$-Schicht (4), wenn sie an der Oberfläche erscheint, in einer Tiefe $e_7$, die geringer ist als die Dicke $e_3$ der Schicht (3), die durch Implantation der ersten Struktur ausgebildet wird und größer oder gleich der Dicke $e_{5'}$ der zweiten Epitaxialschicht aus InP der zweiten Struktur, falls vorhanden, ist, womit der p-Bereich der PIN-Diode und das Gate des J-FET-Transistors gebildet werden.

11. Verfahren nach Anspruch 10, dadurch gekennzeichnet, daß ohmsche Metallisierungen (8, 18, 9, 19) des p-Typs an der Oberfläche der diffundierten Schicht (7) des p-Typs im jeweiligen Bereich der zweiten und der ersten Schichtstruktur stattfinden, womit der p-Kontakt der PIN-Diode und die Gate-Elektrode des J-FET-Transistors hergestellt werden.

12. Verfahren nach Anspruch 11, dadurch gekennzeichnet, daß der p-Kontakt (8, 18) der Diode in Form eines mit einer Kontaktfläche (18) versehenen Ringes (8) und die Gate-Elektrode (9, 19) des Transistors in Form eines mit einer Kontaktfläche (19) versehenen Fingers (9) hergestellt werden.

13. Verfahren nach Anspruch 12, dadurch gekennzeichnet, daß die diffundierte p-Schicht von der Anordnung um die ohmschen p-Kontakte herum, die als Masken dienen, mit Ausnahme des Mittelbereiches des Ringes, der mittels einer Schutzschicht während der Ätzung erhalten bleibt, weggeätzt wird.

14. Verfahren nach Anspruch 13, dadurch gekennzeichnet, daß das Ätzen der p-Schicht unter den Metallisierungen des ohmschen Kontaktes -p, die als Maske dienen, eine laterale Ätzung, Unterätzung genannt, herbeiführt.

15. Verfahren nach Anspruch 14, dadurch gekennzeichnet, daß, wenn die $n^{++}$-Schicht (4) nicht an der Oberfläche erscheint, eine Ätzung in den Schichten der zweiten Struktur außerhalb der diffundierten p-Schicht (7) vorgenommen wird und so einen Bereich der Kontaktshicht des Typs $n^{++}$ freilegt, wobei diese Ätzung eventuell durch die Ätzsperrschicht (6'), falls vorhanden, gestoppt wird.

16. Verfahren nach Anspruch 15, dadurch gekennzeichnet, daß der n-Kontakt (10) der PIN-Diode, die Source- und Drain-Elektroden (11) des Transistors und die Enden (12) des Widerstands R, die derart durch ohmsche Metallisierungen (10, 11, 12) des Typs n hergestellt werden, an der Oberfläche der n-Schicht der ersten Schichtenstruktur und an der Oberfläche der n$^{++}$-Schicht der zweiten Struktur hergestellt werden.

17. Verfahren nach Anspruch 16, dadurch gekennzeichnet, daß die seitlichen Ränder der p-Metallisierung der Gate-Elektrode als Masken beim Herstellen der n-Metallisierungen des Source- und Drain-Bereichs des Transistors nach einem sogenannten Selbstjustierverfahren, das die Unterätzungen verwendet und Kurzschlüsse zwischen den Elektroden zu vermeiden hilft, dienen.

18. Verfahren nach Anspruch 17, dadurch gekennzeichnet, daß am Ende der Ausbildung der n-Metallisierungen eine Ätzung der Schichten um die obengenannten Elemente ($\Delta$, T, R) der integrierten Schaltung herum bis zur oberen Fläche des Substrats stattfindet, womit Isolier-Mesas um die Diode und den Transistor herum gebildet werden, wodurch die Fläche des Widerstandes R zwischen seinen Endmetallisierungen begrenzt wird.

19. Verfahren nach Anspruch 18, dadurch gekennzeichnet, daß es am Ende dieser Ätzung das Auftragen einer dielektrischen Schicht (14) auf der Oberfläche der Anordnung umfaßt, einschließlich der Oberfläche des inneren Bereiches des p-Kontakts als Ring der Diode, des sogenannten Belichtungsbereichs, und unter Ausschluß der elektrischen Kontaktflächen der Diode, des Transistors, der Enden des Widerstandes R sowie der auf dem Substrat vorgesehenen Bereiche zur Herstellung der Massekontakte und der Gleichstromversorgung, wodurch eine Schutzschicht für die Anordnung und eine Antireflexschicht für die Belichtungszone ausgebildet wird.

20. Verfahren nach Anspruch 19, dadurch gekennzeichnet, daß es außerdem an der Oberfläche der dielektrischen Schutzschicht Metallisierungsstreifen (113) umfaßt, die eine Endkontaktfläche des Widerstandes R mit der Kontaktfläche des Transistor-Gates und der p-Kontaktfläche der Diode, die Kontaktfläche des zweiten Endes des Widerstandes R mit der Source S des Transistors und einer Massekontaktfläche M sowie die n-Kontaktfläche der Diode mit einer Gleichstromversorgungs-Kontaktfläche $V_{DD}$ verbinden.

21. Verfahren nach einem der vorhergehenden Ansprüche, dadurch gekennzeichnet, daß das $Ga_xIn_{1-x}As_yP_{1-y}$ folgende Anteile aufweist:

   x = 0,47
   y = 1.

22. Verfahren nach einem der vorhergehenden Ansprüche, dadurch gekennzeichnet, daß das Material InP mit Cr dotiert ist, womit man das Halbleitersubstrat erhält, daß man in die GaInAs-Schicht $Si^{28}$-Ionen in einer Konzentration von $10^{17} \cdot cm^{-3}$ implantiert, womit man die n$^+$-Schicht (3) erhält, daß man in das InP-Material des Wannenbodens $Si^{28}$-Ionen in einer Konzentration von $10^{17} \cdot cm^{-3}$ implantiert, womit man die n$^{++}$-Schicht (4) erhält, daß man in die GaInAs-Schicht Zn-Atome diffundiert, womit man die diffundierte p$^+$-Schicht (7) erhält.

23. Verfahren nach Anspruch 22, dadurch gekennzeichnet, daß die Diffusion von Zn-Atomen im halboffenen Glaskolben bei 530 °C mittels ZnAs2-Dämpfen für die Dauer von ungefähr 10 Min. stattfindet.

24. Verfahren nach einem der vorhergehenden Ansprüche, dadurch gekennzeichnet, daß die Epitaxialschichten durch Epitaxie von Chloriden in der Dampfphase mit ihrer Restdotierungsrate (VPE) hergestellt werden.

25. Verfahren nach einem der Ansprüche 11 bis 24, dadurch gekennzeichnet, daß die ohmschen p-Kontakte aus einer Mehrfachschicht Ti/Pt/Au gebildet werden, die ohmschen n-Kontakte aus der Verbindung Au-Ge, die mit einer Ni-Schicht bedeckt und ausgeheilt wird, um die Legierung zu bilden, gebildet werden, und die Verbindungen zwischen Elementen und der Massekontaktfläche M aus einer Mehrfachschicht Ti/Pt/Au gebildet werden.

26. Verfahren nach einem der Ansprüche 22 bis 25, dadurch gekennzeichnet, daß das Ausheilen nach der Ionenimplantation, mit dem man die n-Schicht der ersten Struktur erhält, ungefähr 15 Min. lang bei ungefähr 700 °C unter Arsen-Partialdruck ($AsH_3$) und das Ausheilen in der Wanne, mit dem man die $n^{++}$-Schicht erhält, bei ungefähr 700 °C ungefähr 1 Stunde lang unter Phosphin- ($PH_3$) und Arsen-Partialdruck ($As2$) im Epitaxiereaktor stattfindet.

27. Verfahren nach einem der vorhergehenden Ansprüche, dadurch gekennzeichnet, daß in dem Maße, in dem es diese Schichten gibt, die Dicken sich wie folgt ergeben (in $\mu$m):

a) bei der ersten Struktur

| | |
|---|---|
| Dicke der Pufferschicht: | $e_1 < 0,2$ |
| Dicke der GaInAs-Epitaxialschicht: | $0,5 < e_2 < 1 \,\mu m$ |
| n-Implantationstiefe in der GaInAs-Expitaxialschicht: | $0,4 < e_3 < 0,9$ |
| p-Diffusionstiefe in der GaInAs-Schicht: | $0,3 < e_7 < 0,7$ |

b) bei der zweiten Struktur

| | |
|---|---|
| $n^{++}$-Implantationstiefe in der Wanne: | $e_4 = 0,6$ |
| Dicke der GaInAs-Schicht als Puffer- und Sperrschicht: | $e_6 = 0,1$ |
| Dicke der ersten InP-Schicht: | $e_5 = 2$ |
| Dicke der GaInAs-Schicht: | $2 < e_6 < 3,5$ |
| Dicke der zweiten InP-Schicht: | $e_{5'} = 1$ |
| Tiefe der Wanne, die die zweite Struktur aufnimmt: | $5 \,\mu m < e_{51} < 5,5 \,\mu m.$ |

FIG.1a

FIG.1b

FIG.1c

FIG. 4

FIG. 1d

FIG. 1e

## FIG. 1f

## FIG. 1g

FIG. 1h

FIG. 1i

FIG. 1 j

FIG. 1 k

FIG. 2a

FIG. 2b

FIG. 2c

FIG. 3a

FIG. 3b

FIG. 3c

FIG. 6

25

FIG. 5

EP 0 317 024 B1